Europäisches Patentamt

European Patent Office

Office européen des brevets

(11) Publication number: **0 508 399 A2**

# EUROPEAN PATENT APPLICATION

(21) Application number: **92106064.6**

(22) Date of filing: **08.04.92**

(51) Int. Cl.5: **C23C 18/12**, C23C 18/08

(30) Priority: **08.04.91 JP 103161/91**
**15.04.91 JP 109901/91**
**23.07.91 JP 206407/91**
**23.07.91 JP 206408/91**

(43) Date of publication of application:
**14.10.92 Bulletin 92/42**

(84) Designated Contracting States:
**DE FR GB**

(71) Applicant: **MITSUBISHI GAS CHEMICAL COMPANY, INC.**
**No. 5-2, Marunouchi 2-chome**
**Chiyoda-ku, Tokyo(JP)**

(72) Inventor: **Hidaka, Toshio**
**c/o Mitsubishi Gas Chemical Co., Inc., 22, Wadai**
**Tsukuba-shi, Ibaraki(JP)**
Inventor: **Kawakami, Takamasa**
**c/o Mitsubishi Gas Chemical Co., Inc., 22, Wadai**
**Tsukuba-shi, Ibaraki(JP)**
Inventor: **Ando, Kazuhiro**
**c/o Mitsubishi Gas Chemical Co., Inc., 22, Wadai**
**Tsukuba-shi, Ibaraki(JP)**
Inventor: **Makinose, Satoru**
**c/o Mitsubishi Gas Chemical Co., Inc., 22, Wadai**
**Tsukuba-shi, Ibaraki(JP)**

(74) Representative: **Brauns, Hans-Adolf, Dr. rer. nat. et al**
**Hoffmann, Eitle & Partner, Patentanwälte**
**Arabellastrasse 4**
**W-8000 München 81(DE)**

(54) **Method of producing thin film-deposited substrate.**

(57) A method of producing a thin film-deposited substrate, which comprises heating a substrate and a metal salt of an organic acid at a temperature of 400°C or less under a reduced pressure in the presence of palladium, to thereby pyrolyze the metal salt and deposit a thin film on the substrate.

EP 0 508 399 A2

## FIELD OF THE INVENTION

The present invention relates to a method of producing a substrate having a thin film deposited thereon by the pyrolysis of an organic acid metal salt. The substrate can be advantageously used in, for example, various electronic devices including resistors, electrodes, sensors, and magnetic media.

## BACKGROUND OF THE INVENTION

In various electronic devices, thin films of a variety of metals or metal oxides are being used. Conventional methods for forming these films include vapor deposition techniques such as vacuum deposition, ion sputtering, ion plating, and the like, chemical vapor-phase or liquid-phase deposition techniques using an organo-metallic compound, and solid-phase reaction techniques using an inorganic metal compound.

However, the deposition techniques using a high-degree vacuum system have had problems concerning cost and raw material handling, because the equipment for film deposition is large-sized and expensive, discharged-gas treatment should be conducted on a large scale and is costly, and raw material compounds are difficult to synthesize, expensive, or poisonous. The liquid-phase or solid-phase deposition techniques which do not require a vacuum system, on the other hand, have been defective in that usable raw material compounds are limited and that since heat treatment is conducted usually at temperatures around 400°C and frequently at temperatures exceeding 600°C, usable substrates are limited to metals, ceramics, glasses, and the like and the deposition techniques usually are not applicable to substrates having lower heat resistance than these materials.

There has been desired a film deposition method which can form, at a lower temperature, a more strongly bonded thin film of various metals or oxides thereof and in which raw material handling is easy.

## SUMMARY OF THE INVENTION

The present inventors have investigated the pyrolytic characteristics of easily available various metal compounds. As a result, it has been found that pyrolysis of cobalt acetate or silver acetate under a reduced pressure may result in formation of a thin film and palladium has the effect of promoting this pyrolysis. The present invention has been completed based on this finding.

Accordingly, the present invention provides a method of producing a thin film-deposited substrate, which comprises heating a substrate and a metal salt of an organic acid at a temperature of 400°C or less under a reduced pressure in the presence of palladium, to thereby pyrolyze the metal salt and deposit a thin film on the substrate.

In a preferred embodiment of the present invention, the organic acid metal salt is at least one member selected from the group consisting of copper formate, magnesium acetate, calcium acetate, strontium acetate, barium acetate, chromium acetate, manganese acetate, iron acetate, cobalt acetate, palladium acetate, copper acetate, silver acetate, zinc acetate, cadmium acetate, indium acetate, tin acetate, and lead acetate.

In another preferred embodiment of the invention, the palladium is adhered to a surface of the substrate and the amount of the palladium adhered to the substrate surface is in the range of from $10^{-7}$ to $10^{-1}$ $g/cm^2$.

In still another preferred embodiment of the invention, the palladium is contained in or is adhered to the organic acid metal salt. In a further preferred embodiment, the palladium is contained in the organic acid metal salt in an amount of from 100 to 6,000 ppm by weight of the metal salt.

## DETAILED DESCRIPTION OF THE INVENTION

Examples of the substrate used in the method of the present invention include resin substrates such as moldings, films, sheets, laminates, and the like produced using heat-resistant thermoplastic resins, super heat-resistant thermoplastic resins, or thermosetting resins all of which are reinforced or not reinforced with fibers. Examples thereof further include various ceramics, glasses, metals, and the like.

The organic acid metal salt used in the present invention is at least one metal salt selected from copper formate and metal salts of acetic acid. Preferred examples of the acetic acid metal salts include magnesium acetate, calcium acetate, strontium acetate, barium acetate, chromium acetate, manganese acetate, iron acetate, cobalt acetate, palladium acetate, copper acetate, silver acetate, zinc acetate, cadmium acetate, indium acetate, tin acetate, and lead acetate.

Of these organic acid metal salts, copper formate, copper acetate, cobalt acetate, and palladium acetate usually give a metal film, and the other metal salts usually give a metal oxide film.

The palladium is usually used in the form of a palladium salt. Examples of the palladium salt include palladium chloride, palladium acetate, palladium nitrate, palladium sulfate, and the like. From the standpoint of avoiding contamination of the deposited thin film with a halogen, sulfur, or other impurities, organic acid salts of palladium such as palladium acetate which decompose at relatively low temperatures are preferred.

According to the present invention, a thin film is deposited on the substrate by subjecting the above-described substrate and organic acid metal salt to heat treatment in the presence of palladium.

The presence of palladium in the heat treatment system can, for example, be attained by (1) using an organic acid metal salt to which palladium is adhered or in which palladium is contained; (2) using a substrate to a surface of which palladium is adhered; or a combination of (1) and (2).

In the case of (1) above, a palladium salt may be added to an organic acid metal salt and dispersed therein by mechanical mixing. It is, however, preferable to use an organic acid metal salt in which palladium is contained in the crystals of the metal salt, in order to obtain better pyrolytic characteristics using palladium in a smaller amount. Such an organic acid metal salt preferably contains palladium in an amount of from 100 to 6,000 ppm by weight of the metal salt.

In the case of (2) above, palladium is adhered to the substrate surface usually in an amount of $10^{-7}$ to $10^{-1}$ g/cm$^2$ or more by, for example, coating the substrate surface with a palladium salt solution in water or organic solvent.

Heating for the pyrolysis in the present invention can be conducted by various heating means. Examples of the heating include radiation heating using far infrared rays, infrared rays, electron beams, microwaves, or the like and heating with an electric furnace, oven, oil, pressurized vapor, nichrome wire, heating plate, or the like. It is preferred in the present invention to employ a heating device that the substrate and metal salt can be heated to and kept at a predetermined temperature with little temperature unevenness over the parts of each of the substrate and the metal salt. Examples of such a heating device include batch heaters, semi-continuous or continuous heaters having an article-introducing part, deposition part, and withdrawal part, and the like.

Further, in order to increase heating rate and reduce the time required for thin film deposition and to obtain a good thin film by diminishing unevenness in heating rate over the parts of the materials being heated, it is preferred to use, for example, a method in which a substrate and a metal salt of organic acid are preheated at a temperature of 150°C or less together with palladium, if required and necessary, and the preheated materials are introduced into a heating device having a heating plate with sufficient heat capacity as a heating part heated at a predetermined temperature, a method in which a substrate and a metal salt is heated by means of infrared rays or, especially, with a far-infrared ceramic heater or the like, or a combination of both methods.

The heating is conducted under a substantially reduced pressure, preferably under a reduced pressure of 30 Torr or less, particularly 5 Torr or less, at a temperature of 400°C or less and not higher than the deformation or deterioration temperature of the substrate, preferably at a temperature of from 130 to 300°C and not higher than the deformation or deterioration temperature of the substrate. Although the substrate usually is heated together with the organic acid metal salt, these may be heated separately. For example, the substrate is heated beforehand to a predetermined temperature in a heater and the organic acid metal salt is then introduced therein and heated.

The materials which have undergone heat treatment as described above are cooled to room temperature, to thereby obtain a substrate having a thin film deposited on a desired part thereof. The thin film-deposited substrate taken out may be put to practical use as is. In the case where the deposited thin film has exceedingly high surface activity and is hence prone to adsorption or oxidation, the thin film-deposited substrate may be subjected to post-processing before being put to practical use. Examples of the post-processing include suitable rust prevention treatment and plating depending on the purpose of use.

According to the method of the present invention, since each of organic acid metal salts has its own temperature range suitable for thin film deposition, it is also possible to use two or more organic acid metal salts and heat-treat the metal salts simultaneously or repeat heat treatment at temperatures suitable to the respective metal salts. Thus, a thin film comprising layers of different metals or metal oxides or other metal compounds can be deposited.

As described above, the method for producing a thin film-deposited substrate in accordance with the present invention does not necessitate a large-scale vacuum system or other large-sized devices, and is also advantageous in that a thin film of a metal or metal oxide can be formed using inexpensive and easily available and handleable materials and especially in that due to the combined use of palladium, the thin film deposition can be conducted at a temperature in a practically sufficiently low temperature range. As a result, a thin film can be easily deposited even on a polyimide substrate or the like. The present invention further enables deposition of a good thin film on glass, ceramic, or metal substrates or other substrates at lower temperatures. Therefore, it is clear that the thin film deposition technique of the present invention is novel and of great practical importance.

The present invention is explained below in more detail by reference to the following Examples and Comparative Examples, but the invention is not to be construed as being limited thereto.

## EXAMPLE 1

A 0.1 wt% palladium acetate solution in acetone was coated on a half of one side surface of a 1 mm thick Pyrex glass plate having a length and width of 100 mm each. The coating was then dried to obtain a palladium-adhered substrate (hereinafter referred to as "substrate 1").

On the other hand, 5 g of a fine powder of cobalt acetate tetrahydrate was uniformly spread on the bottom of a sample dish made of aluminum and having a size of 100 mm by 100 mm by 10 mm (depth) and a wall thickness of 1 mm. This sample dish was covered with substrate 1 with the Pd-coated side facing inside. The covered sample dish was then wrapped wholly with an aluminum foil.

The covered and wrapped sample dish was placed in a vacuum dryer, kept at a temperature of 230°C for 1 hour under a reduced pressure of 5 mmHg, subsequently cooled gradually, and then taken out.

As a result, a 0.1 μm thick cobalt film was deposited on the palladium-coated part of substrate 1. From the sample dish, 3.4 g of the raw material cobalt acetate tetrahydrate remaining undecomposed was recovered.

## EXAMPLE 2

The same procedures as in Example 1 were conducted except that cobalt acetate tetrahydrate containing 1,000 ppm by weight of palladium was used in place of the cobalt acetate.

As a result, a 0.4 μm thick cobalt film was deposited on the palladium-coated part of substrate 1.

## EXAMPLE 3

5 Grams of basic ferric acetate was mixed with 0.011 g of palladium acetate in a mortar. Thin film deposition was then conducted in the same manner as in Example 1 except that the thus-prepared powder mixture was used in place of cobalt acetate and the pyrolysis was conducted at a temperature of 280 to 300°C under a reduced pressure of 1 mmHg. As a result, a thin film was deposited on the palladium-coated part of substrate 1. When this substrate was taken out into the air, heat generation from the film was observed. Examination of the film after heat generation revealed that iron and oxygen atoms were present in the film.

## EXAMPLE 4

200 Milliliters of methanol was added to 50 g of basic copper carbonate to obtain a slurry. On the other hand, 200 ml of an acetone/methanol (80/20 by volume) solution containing 0.4 g of palladium acetate was added to 120 g of 88% formic acid to obtain a uniform formic acid solution. This formic acid solution was added to the above-obtained slurry of basic copper carbonate at room temperature. This mixture was then heated at 65°C for 30 minutes to proceed a reaction.

After completion of the reaction, the resulting mixture was filtered while maintaining at 65°C. The thus-obtained cake was washed three times with 50 ml of methanol and then dried at 80°C under a reduced pressure for 2 hours, thereby obtaining 60 g of anhydrous copper formate containing palladium. ICP (Inductively Coupled Plasma Atomic Emission Spectroscopy) analysis revealed that the palladium content of the copper formate was 0.3% by weight.

A polyimide film was fixed to one side of a 1 mm thick aluminum plate having a length and width of 100 mm each, thereby preparing a substrate (hereinafter referred to as "substrate 2").

Thin film deposition was then conducted in the same manner as in Example 1 except that in place of substrate 1, the above-prepared substrate 2 was used as the cover for the sample dish with the polyimide film-fixed side facing inside and the pyrolysis was conducted at a temperature of 130°C.

As a result, a 0.2 μm thick copper film was deposited on the polyimide film of substrate 2.

## COMPARATIVE EXAMPLE 1

The same procedures as in Example 4 were conducted except that anhydrous copper formate not containing palladium was used in place of the palladium-containing anhydrous copper formate. As a result, copper film deposition did not occur on the polyimide film of substrate 2, and 4.9 g of the raw material anhydrous copper formate was recovered from the sample dish.

## EXAMPLE 5

The same procedures as in Example 4 were conducted except that a uniform mixture obtained by mixing 5 g of magnesium acetate tetrahydrate and 0.02 g of palladium acetate in a mortar was used in place of the palladium-containing anhydrous copper formate, and the pyrolysis was conducted at a temperature of 300°C for 30 minutes under a reduced pressure of 1 mmHg.

As a result, a 0.1 μm thick film of magnesium oxide was deposited on the surface of the polyimide film of substrate 2, which was ascertained by X-ray diffraction.

## EXAMPLE 6

The same procedures as in Example 5 were conducted except that 5 g of zinc acetate dihydrate was used in place of 5 g of magnesium acetate tetrahydrate and the pyrolysis was conducted at 260°C.

As a result, a 0.1 $\mu$m thick film of zinc oxide was deposited on the surface of the polyimide film of substrate 2, which was ascertained by X-ray diffraction.

## EXAMPLE 7

The same procedures as in Example 5 were conducted except that 5 g of cadmium acetate dihydrate was used in place of 5 g of magnesium acetate tetrahydrate, substrate 1 was used in place of substrate 2, and the pyrolysis was conducted at 280°C. As a result, a 0.2 $\mu$m thick film of cadmium oxide was deposited on the palladium-coated part of substrate 1, which was ascertained by X-ray diffraction.

## COMPARATIVE EXAMPLE 2

The same procedures as in Example 7 were conducted except that a 1 mm thick Pyrex glass plate was used in place of substrate 1 and 0.02 g of palladium acetate was not used. As a result, deposition of a thin film of cadmium oxide did not occur on the surface of the Pyrex glass, substrate 1, used as the cover for the sample dish, which was ascertained by X-ray diffraction.

## EXAMPLE 8

The same procedures as in Example 5 were conducted except that 5 g of indium acetate was used in place of 5 g of magnesium acetate tetrahydrate and the pyrolysis was conducted at 240°C. As a result, a 0.1 $\mu$m thick film of indium oxide was deposited on the surface of the polyimide film of substrate 2, which was ascertained by X-ray diffraction.

## EXAMPLES 9 AND 10

The same procedures as in Example 5 were conducted except that each of 5 g of manganese acetate tetrahydrate and 5 g of anhydrous lead(II) acetate was used in place of 5 g of magnesium acetate tetrahydrate and the pyrolysis was conducted at 280°C. As a result, a 0.1 $\mu$m thick manganese oxide film and a 0.2 $\mu$m thick lead oxide film were deposited on the surface of the polyimide film of substrate 2, which was ascertained by X-ray diffraction.

## EXAMPLE 11

The same procedures as in Example 5 were conducted except that 5 g of chromium(III) acetate was used in place of 5 g of magnesium acetate tetrahydrate and the pyrolysis was conducted at 350°C. As a result, a 0.1 $\mu$m thick film of chromium oxide was deposited on the surface of the polyimide film of substrate 2, which was ascertained by X-ray diffraction.

## EXAMPLE 12

The same procedures as in Example 5 were conducted except that 5 g of basic ferric acetate was used in place of 5 g of magnesium acetate tetrahydrate and the pyrolysis was conducted at 300°C. As a result, a thin film of iron oxide was deposited on the surface of the polyimide film of substrate 2, which was ascertained by X-ray diffraction.

## EXAMPLE 13

The same procedures as in Example 5 were conducted except that 5 g of stannous acetate was used in place of 5 g of magnesium acetate tetrahydrate and the pyrolysis was conducted at 260°C. As a result, a thin film of tin oxide was deposited on the surface of the polyimide film of substrate 2, which was ascertained by X-ray diffraction.

## EXAMPLE 14

The same sample dish as in Example 1 was used and a 1 mm thick Pyrex glass plate (substrate 0) was used as the cover for the dish.

On the bottom of the sample dish was uniformly spread 1 g of palladium acetate. This sample dish was covered with substrate 0, and the covered sample dish was wholly wrapped with an aluminum foil.

The wrapped sample dish was placed in a vacuum dryer, kept at 180°C for 0.5 hour under a reduced pressure of 1 mmHg, subsequently cooled gradually, and then taken out.

As a result, a 0.2 $\mu$m thick film of palladium metal was deposited on the inside surface of the Pyrex glass plate used as the cover.

While the invention has been described in detail and with reference to specific embodiments thereof, it will be apparent to one skilled in the art that various changes and modifications can be made therein without departing from the spirit and scope thereof.

**Claims**

1. A method of producing a thin film-deposited substrate, which comprises heating a substrate and a metal salt of an organic acid at a temperature of 400°C or less under a reduced pressure in the presence of palladium, to thereby pyrolyze the metal salt and deposit a thin film on the substrate.

2. A method as claimed in claim 1, wherein said metal salt is at least one member selected from the group consisting of copper formate, magnesium acetate, calcium acetate, strontium acetate, barium acetate, chromium acetate, manganese acetate, iron acetate, cobalt acetate, palladium acetate, copper acetate, silver acetate, zinc acetate, cadmium acetate, indium acetate, tin acetate, and lead acetate.

3. A method as claimed in claim 1, wherein said palladium is adhered to a surface of the substrate.

4. A method as claimed in claim 3, wherein the amount of said palladium adhered to the substrate surface is from $10^{-7}$ to $10^{-1}$ g/cm$^2$.

5. A method as claimed in claim 1, wherein said palladium is contained in or is adhered to the metal salt.

6. A method as claimed in claim 5, wherein said palladium is contained in the metal salt in an amount of from 100 to 6,000 ppm by weight of the metal salt.